# EUROPEAN PATENT APPLICATION

(11) **EP 4 579 272 A1**
(43) Date of publication of application: **02.07.2025**
(21) Application number: 23857723.3
(22) Date of filing: 23.08.2023
(51) Int. Cl.: G01S 7/481, H05K 7/20, G05D 1/20

(54) **SENSOR DEVICE, LIDAR DEVICE, AND VEHICLE**

(30) Priority: 23.08.2022 US 202263400209 P; 29.08.2022 US 202263401727 P; 30.08.2022 US 202263402362 P; 23.05.2023 US 202318322305
(71) Applicant: LG INNOTEK CO. LTD, Gangseo-gu Seoul 07796 (KR)
(72) Inventor: MARATHE, Rituja, Pittsburgh, Pennsylvania 15222 (US); TROWBRIDGE, Christopher John, Pittsburgh, Pennsylvania 15222 (US)
(74) Representative: Plasseraud IP
(86) International application number: PCT/KR2023/012492
(87) International publication number: WO 2024/043691

(57) **Abstract**

A lidar device disclosed in embodiments may comprise: a main frame within which an accommodation part is provided; a plurality of transceivers which are disposed in the accommodation part, emit laser beams toward an object in different directions respectively, and sense laser beams reflected from the object respectively; and a bottom frame under the main frame.

## Description

### TECHNICAL FIELD

The present disclosure relates to a sensor device and a LiDAR device. Particularly, the present disclosure relates to a vehicle having a rotatable sensor device and a rotatable lidar device.

### BACKGROUND ART

An autonomous vehicle (AV) uses a plurality of sensors for recognizing a situation. The sensors, as a portion of a self-driving system (SDS) of the autonomous vehicle, may include at least one of a camera, a light detection and ranging (LiDAR) device, and an inertia measurement unit (IMU). The sensors such as the camera and the LiDAR are used to capture and analyze surrounding scenes of the vehicle. Thereafter, the captured scenes are used to detect an object including a static object such as a fixed structure and a dynamic object such as a pedestrian and other vehicles. Also, data collected by the sensors may be used to detect a condition such as a road mark, a lane curvature, a traffic light, and a sign board. Also, a scene implementation such as a three-dimensional point cloud obtained by the LiDAR of the vehicle may be combined with at least one image obtained by the camera to secure additional insight of a situation or a surrounding scene of the vehicle.

Also, the LiDAR transceiver may include a transmitter that transmits light in ultraviolet (UV), visible, and infrared spectrum regions and at least one photodetector that converts other electromagnetic radiation into an electrical signal. In order to provide reliable object detection and tracking, the optical sensor such as LiDAR requires a firmly fixed optical component, at least one transceiver assembly, a processing and driver circuit, and a sufficient space for cooling components, cleaning components, wires, and motor assemblies. The LiDAR may include transceiver components that are firmly fixed to each another to sustain vibrations of the vehicle and a high-speed rotation of the mechanical LiDAR assembly and to process a balance and weight issue. Also, the LiDAR requires sufficient accommodation packaging and aesthetic features.

### DISCLOSURE OF THE INVENTION

### TECHNICAL PROBLEM

The present disclosure provides a sensor device and a LiDAR device including a plurality of transceivers.

The present disclosure also provides a sensor device and a LiDAR device including a plurality of transceivers that emit and sense laser beams in different directions.

The present disclosure also provides a sensor device and a LiDAR device including a plurality of transceivers having a different divergence angles to emit and sense laser beams in different directions. The present disclosure also provides a device including a plurality of transceivers having different performance specifications and operating purposes.

The present disclosure also provides a sensor device and a LiDAR device including a first transceiver that emits and senses a laser beam in a first direction and a second transceiver that emits and senses a laser beam in a direction opposite to the first direction to axially rotate.

The present disclosure also provides a sensor device and a LiDAR device including a pair of transceivers arranged in opposite directions to provide a compact rotation assembly, thereby reducing a weight, an aerodynamic drag, and/or a wind noise caused by high-speed rotation.

The present disclosure also provides a sensor device and a LiDAR device in which the centers of gravity of respective transceivers are disposed at opposite sides based on a rotation center by improving the inertial mass effect of an optical sensor during rotating.

The present disclosure also provides a sensor device and a LiDAR device having a rigid structure that allows modular attachment of components such as cooling components, window components, and cleaning components, has an accommodation space, and provides sufficient sealing from external and environmental elements.

The present disclosure also provides transceivers arranged in parallel to both sidewalls of an external housing. The present disclosure also provides heat dissipation members in the external housing to absorb and release heat generated by the transceivers. According to an embodiment of the present invention, a lens pare may be disposed on one side or a front side of each transceiver, and a heat dissipation member may be disposed on the other side or a rear side thereof. Each heat dissipation member may have a shape corresponding to a cylindrical shape of the external housing and contact a front window or one side of a first transceiver and a rear portion of the other side of a second transceiver.

The present disclosure also provides a sensor device and a LiDAR device capable of preventing optical interference or crosstalk between two or more transceivers. According to an embodiment of the present invention, inertial mass effects in a rotating LiDAR device may be improved. That is, the centers of gravity of respective transceivers may be disposed at opposite sides based on a rotation center to minimize a movement during rotation of respective transceivers.

The present disclosure also provides a mounting device for a sensor device and a LiDAR device, which includes a plurality of accommodation parts, e.g., six fasciae. Respective accommodation parts have structural features for accommodating at least one component of a sensor assembly. For example, at least one of the six accommodation parts may accommodate modular cooling components. Similarly, at least one of the six accommodation parts may accommodate a modular detachable optical window. At least one of the six accommodation parts may robustly protect transceiver assemblies. Thus, the mounting device may accommodate a plurality of different type components and provide a rigid mounting structure.

The present disclosure also provides a mounting device that provides a rigid structure, allows modular attachment of components such as cooling components, window components, and cleaning components, provides a space for accommodating the components, and provides sufficient sealing from external and weather elements.

The present disclosure also provides a LiDAR sensor system including a housing for fixing the components in place and accommodating electronic devices, optical components, cooling components, and architectural or structural components. An enclosure may be designed to provide both functional and aesthetic solutions to the LiDAR sensor system and to maximize an inflow and outflow of airflow for cooling and cleaning. The enclosure may provide an aerodynamic housing for the LiDAR sensor system.

### TECHNICAL SOLUTION

An embodiment of the present invention provides a LiDAR device including: a main frame having an accommodation part therein; a plurality of transceivers which are disposed in the accommodation part and each of which emits a laser beam toward an object in different directions and senses the laser beam reflected by the object; and a bottom frame disposed below the main frame.

In an embodiment, the plurality of transceivers may include: a first transceiver configured to emit and sense a laser beam in a first direction; and a second transceiver configured to emit and sense a laser beam in a direction opposite to the first direction.

In an embodiment, the LiDAR device may further include an upper cover or an upper frame disposed above the first and second transceivers and coupled to an upper inner circumference of the main frame, in which the bottom frame may be coupled to a lower inner circumference of the main frame.

In an embodiment, each of side surfaces of the main frame may include an accommodation part passing therethrough, and the main frame may include frames having heat dissipation members coupled to the accommodation parts, respectively, of each of the side surfaces of the main frame.

In an embodiment, the LiDAR device may further include a first window disposed at a beam incidence side of the first transceiver and a second window disposed at a beam incidence side of the second transceiver, in which each of the first and second windows may be disposed outward relative to the main frame.

In an embodiment, the first transceiver may include a first receiving optical system and a first sensor array, and the second transceiver may include a second receiving optical system and a second sensor array, in which the LiDAR device may further include a first lens tube disposed between the first receiving optical system and the first window and a second lens tube disposed between the second receiving optical system and the second window.

In an embodiment, the LiDAR device may further include heat dissipation covers that cover the heat dissipation members disposed on the side surfaces of the main frame, respectively, in which each of the heat dissipation covers may have a hole that exposes the window.

In an embodiment, the bottom frame may have a heat dissipation hole corresponding to a lower portion of each of the heat dissipation members.

In an embodiment, the LiDAR device may further include a housing that covers upper and outer portions of the main frame, in which the housing may include a window hole corresponding to the hole of each of the heat dissipation covers.

In an embodiment, the LiDAR device may further include: a fixed frame fixed to a moving body and having a stator; and a rotation frame having a rotor that faces the stator and configured to rotate axially on the fixed frame, in which the rotation frame may allow the main frame, the bottom frame, and the plurality of transceivers to rotate.

In an embodiment, the plurality of transceivers may have different incident receiving fields of view.

The additional scope of the applicability of the present invention will become apparent from the following detailed description. However, the detailed description and specific examples show only examples of preferred embodiments of the present invention because various modifications and alterations will be apparent to those skilled in the art from the detailed description within the spirit and scope of the present invention. The present invention will be more fully understood from the following detailed description and the accompanying drawings, which are provided for illustrative purposes and therefore do not limit the present invention.

### ADVANTAGEOUS EFFECTS

According to the embodiment of the present invention, the components such as the cooling components, the window components, and the cleaning components may be supported and coupled in the modular attachment manner, and may be sufficiently protected and sealed from external impacts and weathers. Also, the components may be accommodated and supported, and the components may easily protected and coupled. Also, the components may be detached from the device.

According to the embodiment of the present invention, the pair of transceivers arranged in different or opposite directions may allow the miniaturization of the device and the reduction in weight, aerodynamic drag, and/or wind noise caused by high-speed movement. Also, the packaging efficiency of the sensor head assembly may be improved. Also, the optical interference caused by the different transceivers may be prevented.

According to the present invention, as the heat dissipation members are disposed on two or more side surfaces, the heat dissipation efficiency may be improved.

The embodiment of the present invention may obtain the optical images at the different divergence angles in different directions through the rotation imaging device such as the LiDAR device and the sensor device to improve the sensing efficiency of the surrounding areas.

### BRIEF DESCRIPTION OF THE DRAWINGS

FIG. 1 is a perspective view of a vehicle including a LiDAR device according to an embodiment of the present invention.
FIG. 2 is a block diagram illustrating an example of a vehicle system including the LiDAR device of FIG. 1.
FIG. 3 is a block diagram illustrating first and second transceivers of the LiDAR device of FIG. 2.
FIG. 4 is a perspective view illustrating the LiDAR device according to an embodiment of the present invention.
FIG. 5 is a transparent view illustrating the LiDAR device of FIG. 4.
FIG. 6 is a perspective view illustrating a housing of the LiDAR device of FIG. 4.
FIG. 7 is a plan view illustrating inner components of the LiDAR device of FIG. 4.
FIG. 8 is an exploded perspective view illustrating inner and outer components of frames in the LiDAR device of FIG. 4.
FIG. 9 is a plan view illustrating coupling of the components in FIG. 8.
(a) and (b) of FIG. 10 are side cross-sectional views illustrating first and second transceivers integrated to a main frame of the LiDAR device according to the present invention.
FIG. 11 is a partial cross-sectional view illustrating the first and second transceivers in the LiDAR device according to the present invention.
FIG. 12 is a perspective view illustrating an example of coupling of a first frame, the first transceiver, and a heat dissipation member of FIG. 8.
FIG. 13 is a perspective view illustrating an example of coupling of the first frame and the first transceiver of FIG. 8.
FIG. 14 is a perspective view illustrating an example of coupling of a second frame and the second transceiver of FIG. 8.
FIG. 15 is a plan view illustrating a cut upper portion of the housing of FIG. 4.
FIG. 16 is a perspective view for explaining the heat dissipation member in the housing of FIG. 15.
FIG. 17 is an exploded perspective view of FIG. 16.
FIG. 18 is a view for explaining a light path of the first and second transceivers of the LiDAR device of FIG. 16.
FIG. 19 is a view illustrating a modified example of the main frame and the heat dissipation cover in the LiDAR device according to an embodiment of the present invention.
FIG. 20 is a view for explaining a beam path and a center of the first and second transceivers in FIG. 19.
FIG. 21 is a view for explaining the beam path of the first and second transceivers of FIG. 19.
FIG. 22 is a perspective view for explaining a window and a heat dissipation cover at an output side of respective transceivers in the LiDAR device according to an embodiment of the present invention.
FIG. 23 is a perspective view illustrating a side frame and a window of FIG. 22.
FIG. 24 is a view for explaining the window and the heat dissipation cover of FIG. 22.
FIG. 25 is a view for explaining the window and the heat dissipation cover of FIG. 23 as another example of the present invention.
FIG. 26 is a view illustrating an air guide and a heat dissipation cover of a side frame to which each window in FIG. 23 is coupled.
FIG. 27 is a partial cross-sectional view illustrating a state in which the housing and the upper cover are fastened to each other using a fastening member in the LiDAR device according to the present invention.
FIG. 28 is a perspective view illustrating the fastening member coupled to the housing and the upper cover of FIG. 27.

### MODE FOR CARRYING OUT THE INVENTION

Hereinafter, embodiments will be described in detail with reference to the accompanying drawings, in which like reference numerals refer to like components. However, the present invention may be implemented in various forms and is not limited to the embodiments exemplified in this specification. Rather, these embodiments are provided as examples to make the disclosure thorough and complete and to fully convey the features and functions of the invention to those skilled in the art. Accordingly, processes, elements, and techniques that are not necessary for a full understanding of the features and functions of the invention by those skilled in the art may not be described. Unless specifically mentioned otherwise, similar reference numerals in the accompanying drawings and written description denote similar components, and their descriptions will not be repeated.

A LiDAR system may be referred to as a depth detection system, a laser distance measurement system, a laser radar system, a LiDAR system, or a laser/optical detection and ranging (LADAR) system. LiDAR is a kind of distance measurement sensor having a long detection range, a high resolution, and a low interference caused by environment. The LiDAR is widely applied in fields of intelligent robots, unmanned aerial vehicles, autonomous driving, or self-driving. The LiDAR has an operation principle that estimates a distance based on a round trip time of an electromagnetic wave (e.g., time of flight or delay time) between a source and a target.

In general, the LiDAR systems, such as a direct time-of-flight (D-TOF) LiDAR system, emit a light pulse (e.g., laser pulses) toward an object and measure a time taken for the light pulse to be reflected by the object and detected by the sensor of the LiDAR system to measure a distance (e.g., depth) to the object. For example, repeated measurements for generating an individual histogram of relative time-of-flight (hereinafter, referred to as TOF) based on repeated measurements may be performed to reduce noise from ambient light, and a peak of the individual histogram may be calculated to detect an event (e.g., to detect a point of an object or a depth of an area, which re-reflects the light pulse).

The above-described aspects and features of the embodiment of the present invention will be described in more detail with reference to the accompanying drawings.

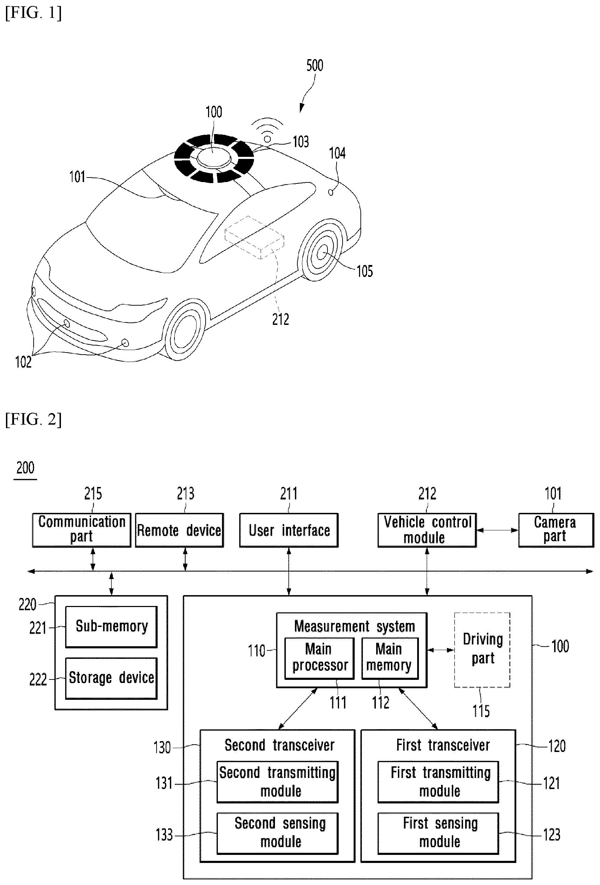

FIG. 1 is a perspective view of a vehicle including a LiDAR device according to an embodiment of the present invention.

Referring to FIG. 1, a moving body such as a vehicle 500 may include a LiDAR device 100, a camera part 101, vehicle recognition sensors 102 and 104, a global positioning system (GPS) sensor 103, a vehicle control module 212, and an ultrasonic sensor 105.

The LiDAR device 100 that is a rotary imaging device or a sensor device is coupled to a portion of the vehicle 500 and rotates 360°. The LiDAR device 100 senses a distance between the vehicle and an object (static object or dynamic object), a surrounding environment, and a shape thereof and controls a driving of the vehicle b using measured data. 3-dimensional point cloud using the above-described sensing technology may collect and analyze surrounding objects and environment of the vehicle and generate detection data that provide information on objects disposed within an appropriately close range.

The LiDAR device 100 may communicate with a vehicle control module 212 and transmit/receive information related to the driving of the vehicle. The vehicle control module 212 may perform all sorts of controls while communicating with various systems or sensors in the vehicle. The vehicle control module 212, as a device for controlling and monitoring various systems of the vehicle, may include a control device such as an electronic control unit (ECU). The vehicle control module 212 may communicate with an external mobile device and be electrically connected to a detachable storage device.

One or a plurality of camera parts 101 may be mounted to the inside and/or the outside of the vehicle to photograph front and/or rear images of a moving vehicle and provide or store the photographed images through a display device (not shown). The photographed image data may selectively include audio data. For another example, the camera part 101 may be mounted to each of a front portion, a rear portion, each corner, or each side surface of the vehicle 500 to photograph surrounding images of the vehicle and provide the photographed images through the display device (not shown). The vehicle control module 212 or another processor may distinguish a traffic light, a vehicle, and a pedestrian based on the data photographed by the camera part 101 and provide the obtained information to a driver. This camera part 101 may be used as a driving assistant device.

A plurality of front radars 102 are installed at the front portion of the vehicle 500 to detect a distance between the vehicle 500 and a front object. A plurality of rear radars 104 are installed at the rear portion of the vehicle 500 to detect a distance between the vehicle 500 and a rear object. When object information is detected through the radars 102 and 104, a surrounding object or obstacle is detected and notified to the driver through an alarm or warning message.

A GPS sensor 103 may receive a signal from a satellite and provide the received signal to a device such as the vehicle control module 212, the LiDAR device 100, and the camera part 101, and the device may provide or calculate information such as a position, speed, or time of the vehicle based on a GPS position signal.

The ultrasonic sensor 105 may sense a distance between the vehicle and a vehicle or obstacle disposed adjacent thereto, so that the vehicle safely parks in a parking space. Also, the ultrasonic sensor 105 may prevent an accident that may occur while driving. The ultrasonic sensor 105 may be installed on the rear portion, the side surface, or wheels of the vehicle.

As illustrated in FIG. 2, a vehicle system 200 including the LiDAR device 100 and the vehicle control module 212 receives an input from a user or driver or provides information to the user or driver through a user interface 211. The user interface 211 may include a display device, a touch panel, a button, a voice recognition, or a wired or wireless input device and connect the driver and various devices in a wired or wireless manner for communication therebetween.

The vehicle system 200 may communicates with a remote device 213, and the remote device 213 may remotely communicate with the user or an external device or receive an external control signal. The communication part 215 may support a wired or wireless communication, e.g., a wired or wireless communication module.

The storage part 220 may include at least one sub-memory 221 therein. Also, the storage part 220 may include a portable or detachable storage device 222. The LiDAR device 100 may communicate with the user interface 211 and the camera part 101.

The LiDAR device 100 may include a driving part 115 like a motor, and the driving part 115 may rotate a portion or a whole of the LiDAR device 100 by 360° based on a control signal. The driving part 115 may communicate with an inner component of the LiDAR device 100, such as a measurement system 110, and allow the LiDAR device 100 to axially rotate.

The LiDAR device 100 may include the measurement system 110 and at least one transceiver 120 and 130. The driving part 115 may be rotatably coupled to the measurement system 110 and the transceivers 120 and 130 and provide driving force thereto.

The measurement system 110 may include a main processor 111 and a main memory 112. The main processor 111 may be realized by a general processor, an application specific integrated circuit (ASIC), at least one field programmable gate array (FPGA), a group of processing components, or other suitable electronic processing components. The main memory 112 (e.g., a memory, a memory unit, and a storage device) may include at least one device (e.g., RAM, ROM, a flash memory, and a hard disk storage) for storing data and/or computer code to complete or facilitate various processes described in the present invention. The main memory 112 may be or include a volatile or non-volatile memory. The main memory 112 may include database components, object code components, script components, or other types of information structures to support various activities and information structures described in the present invention. According to an embodiment, the main memory 112 may be communicatively connected to the main processor 111.

The measurement system 110 may include at least one processor (also referred to as a central processing unit or CPU). At least one processor may be connected to a communication infrastructure or bus. Also, at least one processor may be a graphics processing unit (GPU). In some examples, the GPU may include a processor that is a specialized electronic circuit designed to process mathematically intensive applications. The GPU may have a parallel structure that is efficient for parallel processing of large capacity data blocks such as mathematically intensive data that are commonly used in computer graphics applications, images, and videos.

The measurement system 110 that is a computer system may be connected to at least one user input or output device such as a monitor, a keyboard, or a pointing device which communicates with a communication infrastructure through a user input or output interface.

At least one transceiver 120 and 130, e.g., a plurality of transceivers, may be disposed in the LiDAR device 100. The plurality of transceivers 120 and 130 may emit and sense laser beams in different directions based on a rotation axis. Here, the different directions may be in a range from 10° to 180°. For example, the plurality of transceivers may be arranged at one of 30°, 60°, 90°, 120°, 150°, and 180°, preferably, 180°.

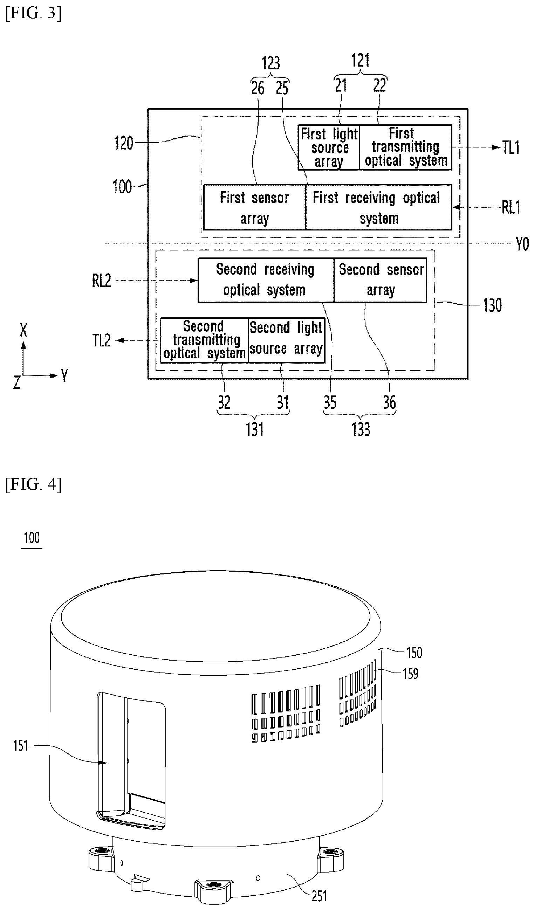

As illustrated in FIG. 3, the plurality of transceivers 120 and 130 may emit and sense laser beams in opposite directions. To this end, light source arrays 21 and 31 of the plurality of transceivers 120 and 130 may be disposed at opposite sides, and receiving optical systems 25 and 35 may be arranged in opposite directions based on an inner center of the LiDAR device 100.

The plurality of transceivers 120 and 130 may have different divergence angles or fields of view. The plurality of transceivers 120 and 130 may scan objects at different elevations. Since the LiDAR device includes the plurality of transceivers 120 and 130 therein, the rotary imaging device may be miniaturized and have a distributed weight to obtain a rotation balance. The plurality of transceivers 120 and 130 may have different vertical fields of view (i.e., elevations). The plurality of transceivers 120 and 130 may have different horizontal fields of view.

The plurality of transceivers 120 and 130 may include a first transceiver 120 and a second transceiver 130. The first transceiver 120 may include a first transmitting module 121 and a first sensing module 123, and the second transceiver 130 may include a second transmitting module 131 and a second sensing module 133. The first transmitting module 121 of the first transceiver 120 transmits a laser beam, and the first sensing module 123 senses the laser beam transmitted by the first transmission module 121. The second transmitting module 131 of the second transceiver 130 transmits a laser beam, and the second sensing module 133 senses the laser beam transmitted by the second transmission module 131.

As illustrated in FIG. 3, the first transmitting module 121 may include a first light source array 21 and a first transmitting optical system 22. The first sensing module 123 may include a first receiving optical system 25 and a first sensor array 26. The first transmitting module 121 emits a first transmission laser beam TL1 toward an object, and the first sensing module 123 senses the first receiving laser beam RL1 reflected by the object.

The second transmitting module 131 may include a second light source array 31 and a second transmitting optical system 32. The second sensing module 133 may include a second receiving optical system 35 and a second sensor array 36. The second transmitting module 131 emits a second transmitting laser beam TL2 toward an object, and the second sensing module 133 senses the second receiving laser beam RL2 reflected by the object.

The first transmitting laser beam TL1 is emitted in a first direction Y, and the second transmitting laser beam TL2 is emitted in a direction opposite to the first direction. That is, the first and second transmitting laser beams TL1 and TL2 emit light in 180° opposite directions based on a central position thereof to scan objects disposed on 180°.

The first and second transmitting modules 121 and 131 may include a general processor, a processor such as ASIC, or FPGA, or a control module, which is capable of performing driving control of the first and second light source arrays 21 and 31 and transmission control of optical signals and may further include an internal memory that stores a code for controlling generation of the laser beams.

The first and second light source arrays 21 and 31 may include one-dimensional or two-dimensional arrays and may be individually addressable or controllable. The first and second light source arrays 21 and 31 may include a plurality of light sources that generate laser beams or optical pulses. The light sources may include a laser diode (LD), an edge-emitting laser, a vertical-cavity surface-emitting lasers (VCSEL), a distributed feedback laser (DFB), a light-emitting diode (LED), and a super luminescent diodes (SLD). However, the embodiment of the present invention is not limited thereto.

The first and second light source arrays 21 and 31 may include a plurality of electrically connected surface emitting laser diodes such as VCSEL arrays, each of which is individually addressable or controllable. The first and second light source arrays 21 and 31 may be realized one-dimensional (Q*P) or two-dimensional VCSEL array having Q rows and P columns. Here, each of Q and P (rows and columns) may be two or more (Q > P). Also, a plurality of VCSEL arrays may be grouped to form an individual light source. The number of light sources of the first light source array 21 may be equal to or different from that of light sources of the second light source array 31.

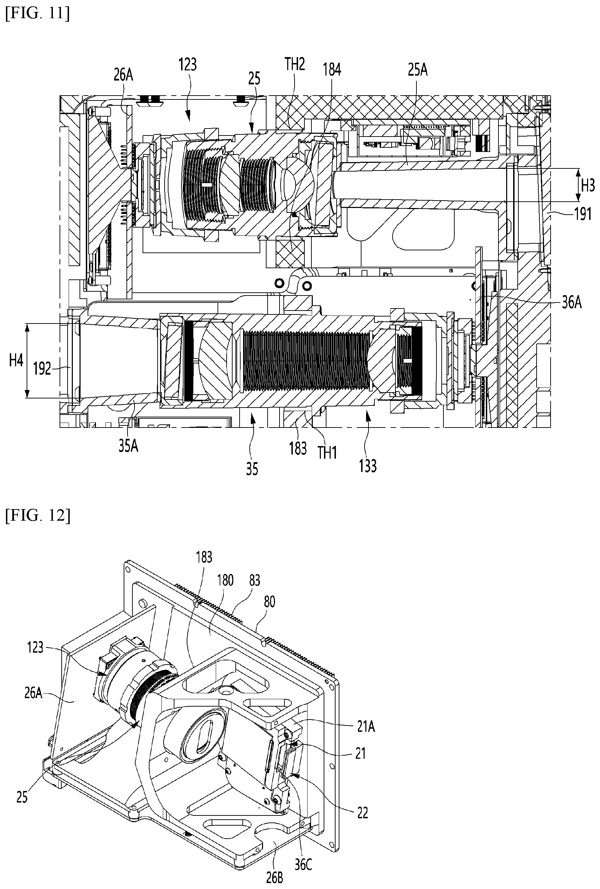

The optical signal emitted from the first and second light source arrays 21 and 31 may be transmitted toward an object through the first and second transmitting optical systems 22 and 32. Each of the first and second transmitting optical systems 22 and 32 may include at least one lens or include at least one lens and a microlens array 26C or 36C (refer to FIG. 12) disposed in front of the lens. Each of the first and second transmitting optical systems 22 and 32 may include one optical lens or a plurality of optical lenses to shape the laser beams in a desired manner. That is, the first and second transmitting modules 121 and 131 may set an emitted direction or angle of light generated by the first and second light source arrays 21 and 31 according to control of the main processor 111. Also, the LiDAR device 100 may include a beam splitter (not shown) for overlapping or separating the first transmitting laser beam TL1 and the first receiving laser beam RL1 therein.

The first and second transmitting modules 121 and 131 may emit pulsed light or continuous light toward an object that is a target to be scanned a plurality of times. The main processor 111 may generate a start signal at a light transmission time and provide the generated start signal to a time to digital converter (TDC). The start signal may be used for calculating a time of flight (TOF) of light.

The first and second sensing modules 123 and 133 may include a processor that converts a raw histogram based on a signal sensed through the first and second receiving optical systems 25 and 35 and having a matching filter, a peak detection circuit, and a SPAD saturation and quenching circuit. The processor may be realized by a general processor, an application specific integrated circuit (ASIC), at least one field programmable gate array (FPGA), a group of processing components, or other suitable electronic processing components. The first and second sensing modules 123 and 133 may include a memory (not shown) having at least one device (e.g., RAM, ROM, a flash memory, and a hard disk storage) to store a detected optical signals therein.

The first and second sensor arrays 26 and 36 may receive the laser beams RL1 and RL2 reflected or scattered from an object through the first and second receiving optical systems 22 and 32. Each of the first and second sensor arrays 26 and 36 may include a detector that is divided into a plurality of pixels, and a light detection component may be disposed in each of the plurality of pixels. Each of the first and second receiving optical systems 22 and 32 may be an optical component designed to collect reflected light into a predetermined pixel.

When the reflected light is received by the first and second sensor arrays 26 and 36, the first and second sensing modules 123 and 133 may convert the reflected light into a stop signal. The stop signal may be used to calculate the TOF of the light together with the start signal. Each of the first and second sensor arrays 26 and 36 or the first and second sensing modules 123 and 133 may include TDC for measuring the TOF of light detected by each of the plurality of photodetectors. Each of the photodetectors may be a light receiving element that generates an electrical signals in response to detected optical energy.

Each of the first and second sensor arrays 26 and 36 may be realized as a one-dimensional or two-dimensional array and may be a photodetector such as a single avalanche photo diode (SPAD) or an avalanche photo diode (APD). In an embodiments of the present invention, each of the first and second sensor arrays 26 and 36 may be realized by using a photodetector. The first and second sensor arrays 26 and 36 measure a light pulse, i.e., light corresponding to an image pixel, through the first and second receiving optical systems 25 and 35. For example, each of the first and second sensor arrays 26 and 36 may be arranged as a two-dimensional SPAD array having M rows and N columns. Here, each of M and N may be 2 or more. Also, a plurality of SPAD sub-arrays may be grouped to form an optical sensor. For example, the first and second sensor arrays 26 and 36 may use Geiger mode, i.e., Geiger mode APD (GmAPD).

The main processor 111 processes a signal by using light detected by the first and second sensing modules 123 and 133 to obtain information of an object. The main processor 111 determines a distance to the object based on the TOF of the light reflected from the object and performs data processing to analyze a position and a shape of the object. The information analyzed by the processor 111, i.e., the shape and position of the object, may be transmitted to another device.

The first and second transmitting optical systems 22 and 32 may refract light pulses generated by the first and second light source arrays 21 and 31 and emit the refracted light pulses toward the object. The light pulses may be incident to and reflected by a surface of an object, and the reflected light pulses may be sensed by the first and second sensor arrays 26 and 36 through the first and second receiving optical systems 25 and 35. A distance or depth to the object may be determined based on the TOF that is a time elapsed from emission to detection of the light pulses. The LiDAR device 100 may provide information on a scene or situation around a vehicle by using the obtained data and be coupled with at least one image data obtained by the camera part 101 to obtain an additional insight.

As illustrated in FIG. 3, the LiDAR device 100 includes the first transceiver 120 disposed at one side and a second transceiver 130 disposed at the other side based on a central axis Y0 passing through a horizontal first direction Y. As the first and second transceivers 120 and 130 are distributed at both sides based on the central axis Y0, the LiDAR device 100 may maintain a weight balance or rotation balance. The central axis Y0 may be a straight line passing through a center between both sides of the LiDAR device 100 in a second direction X.

The first transceiver 120 transmits and receives the first laser beam L1 in the first direction Y. The second transceiver 130 transmits and receives the second laser beam L2 in the direction opposite to the first direction Y. Thus, light interference caused by the transmitting and receiving of the first and second laser beams L1and L2 may be prevented. Also, a distance between the first transmitting optical system 22 and the second transmitting optical system 32 may be greater than that between the first receiving optical system 25 and the second receiving optical system 35.

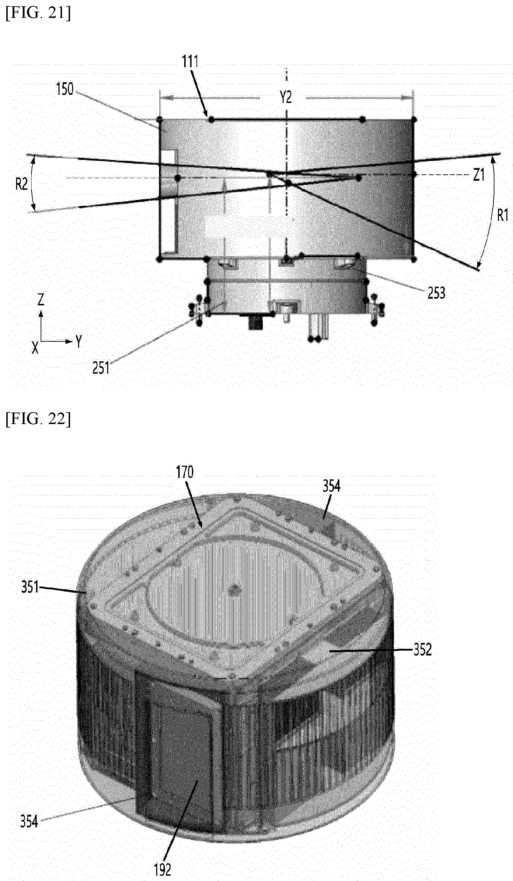

As illustrated in FIGS. 4 to 8, the LiDAR device 100 may include a fixed frame 251, a rotation frame 253 (refer to FIG. 21), a housing 150, and a main frame 170 and transceivers 120 and 130 in an inner space 150A of the housing 150.

The fixed frame 251 includes a stator therein, which may be fixed to a cover or upper case of a vehicle or a moving body. The fixed frame 251 may include fastening parts 12 along an outer circumference thereof and be coupled to the same vehicle as the moving body by using a plurality of fastening members 11. The fixed frame 251 may have a top view shape that is a circular or ring shape.

As illustrated in FIG. 21, the rotation frame 253 may face an inner structure of the fixed frame 251, include a rotor (not shown), and rotate on the fixed frame 251. The stator may be a coil, and the rotor may be also a coil. The stator and the rotor may form a driving part, e.g., a motor. A structure for guiding a rotation of the rotation frame 253 and preventing detachment may be disposed on one or a plurality of areas of each of the rotation frame 253 and the fixed frame 251, and this structure may include a rotation guide or a rotation shaft (not shown). The rotation frame 253 may have a top view shape that is circular or ring shape. The rotation frame 253 may be a rotation platform.

As illustrated in FIGS. 4 to 6, the housing 150 may have a cylindrical shape having an opened bottom portion and a closed top portion. The housing 150 may extend outward above the rotation frame 253. The housing 150 may rotate together with the rotation frame 253. The housing 150 may serve as an enclosure that covers inner components and be made of a heat dissipating material.

A plurality of perforations 159 may be arranged on a predetermined area of a circumferential surface of the housing 150 for heat dissipation. The plurality of perforations 159 may be arranged on at least two areas in vertical and rotational directions. The perforations 159 may have the same size as each other or may include at least one perforation having a different size.

The housing 150 may include window holes 151 and 152. The window holes 151 and 152 each having a predetermined size may be formed between upper and lower ends of the housing 150. For example, each of the window holes 151 and 152 may have a size greater than that of each of windows 191 and 192 through which light is transmitted and received by each of the transceivers 120 and 130. The window holes 151 and 152 may be disposed in entrance areas of the windows 191 and 192 to expose the windows 191 and 192, respectively.

A rotation head part 111 may be coupled to each of an upper portion of the rotation frame 253 and the inside of the housing 150. The rotation head part 111 may have a cylindrical shape and rotate together with the rotation frame 253. A cover frame 141 of the rotation head part 111 prevents foreign substances from being introduced into an internal space in which inner components such as the transceivers 120 and 130 and other components are stored. The cover frame 141 may have a circular or polygonal shape and be made of a metal frame material or a transparent plastic material.

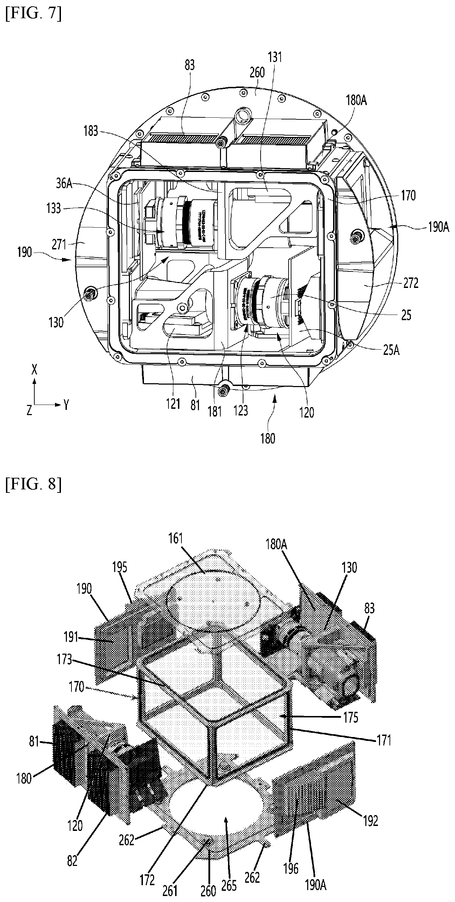

One cover frame 141 may be provided or a plurality of cover frames 141 may be stacked with each other. As illustrated in FIG. 7, the cover frame 141 may be tightly coupled with the main frame 170. Here, the tight coupling may refer to a coupling of two structures having fitting structures or stepped structures or a fastening by a plurality of fastening members. The tight coupling may include a sealing member to prevent moisture being introduced from the outside.

The bottom frame 260 supports components of the rotation head part 111. The bottom frame 260 may have a circular shape and have a diameter greater than that of the fixed frame 251. One or a plurality of the bottom frames 260 may be stacked with each other. The bottom frame 260 may have a bottom area greater than that of the main frame 170 illustrated in FIG. 7.

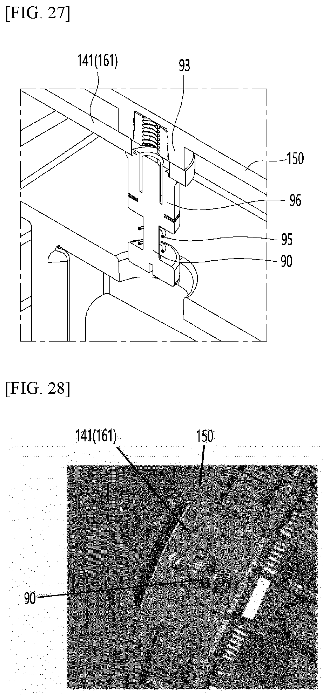

The cover frame 141 may be fastened to a first fastening part 93 disposed on an inner upper circumference of the housing 150 through a fastening members 90 (refer to FIG. 27). The bottom frame 260 may be fastened to a second fastening part 91 disposed on an inner lower circumference of the housing 150 through a fastening member (not shown). The cover frame 141 may have the same shape as or a different shape from to an upper cover 161 or 162 to be described later, one of which may be removed.

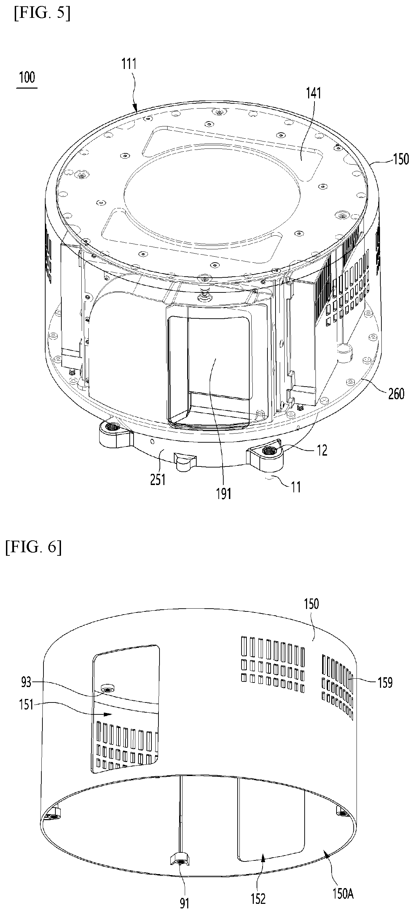

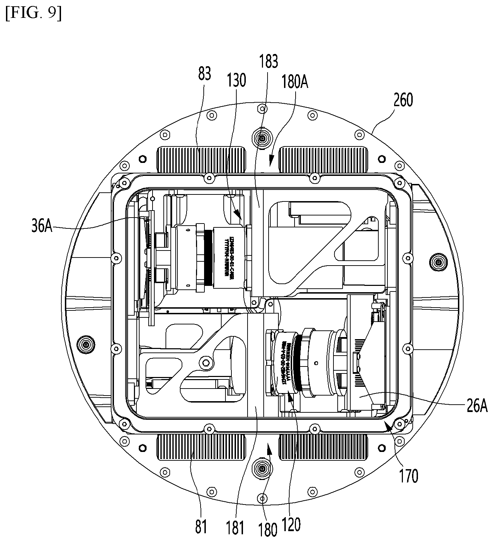

As illustrated in FIGS. 7 to 13, in the housing 150 of the LiDAR device 100, an optical component such as the transceivers 120 and 130, a heat dissipation component for heat dissipation, a frame component for supporting and coupling inner components, and a cover component for protecting the inner components may be coupled to each other. The rotation head part 111 illustrated in FIG. 5 may include the optical component, the heat dissipation component for heat dissipation, the frame component for supporting and coupling the inner components, and the cover component for protecting the inner components.

The optical components include the first and second transceivers 120 and 130. The first transceiver 120 may include one or a plurality of circuit boards 21A, 26A, and 26B electrically connected to the first light source array 21 and/or the first sensor array 26. The first sensor array 26 may be disposed on the first circuit board 26A, and the first light source array 21 may be disposed on a different driver board 21A. The first transceiver 120 may be disposed on the first main board 26B, and the first main board may be electrically connected to the above-described boards.

The second transceiver 130 may include one or a plurality of circuit boards 31A, 36A, and 36B electrically connected to the second light source array 31 and/or the second sensor array 36. The second sensor array 36 may be disposed on the second circuit board 36A, and the second light source array 31 may be disposed on a different driver board 31A. The second transceiver 130 may be disposed on the second main board 36B, and the second main board 36B may be electrically connected to the above-described boards

The first circuit board 26A may be disposed between the first receiving optical system 25 and the main frame 170. The second circuit board 36A may be disposed between the second receiving optical system 35 and the main frame 170. The first circuit board 26A and the second circuit board 36A may be disposed at opposite sides based on the main frame 170. As the first and second transceivers 120 and 130 are disposed in opposite directions, the light source arrays, sensor arrays, and circuit boards of respective transceivers may be distributed to improve a heat dissipation efficiency and maximize a space usage. Also, a cooling system having heat dissipation members on at least three sides of each of the transceivers may be provided to improve degradation of heat dissipation and prevent degradation in performance of the LiDAR system caused by heat.

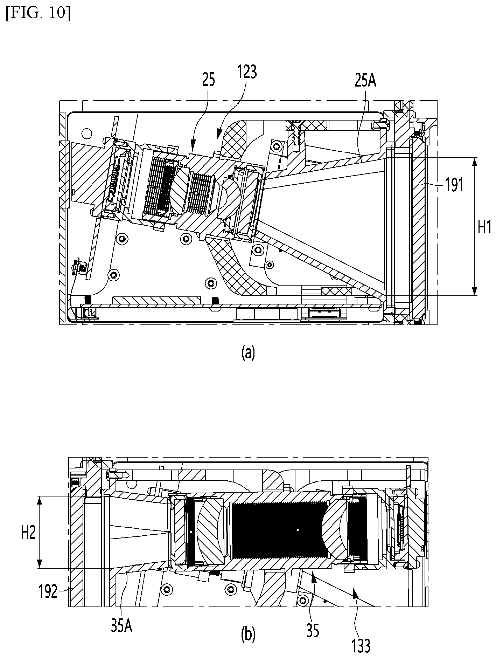

As illustrated in FIGS. 10 and 11, the first transceiver 120 may include a first lens tube 25A disposed at a light incidence side (front side) of the first receiving optical system 25 to receive light. The second transceiver 130 may include a second lens tube 35A disposed at a light incidence side (front side) of the second receiving optical system 35 to receive light. The first lens tube 25A may have an entrance shape or area different from that of the second lens tube 35A. The first lens tube 25A may form a portion of the first receiving optical system 25. The second lens tube 35A may form a portion of the second receiving optical system 35.

Here, the first transceiver 120, the first lens tube 25A, and the circuit boards 21A, 26A, and 26B may be defined as a first transceiver assembly. Also, the second transceiver 130, the second lens tube 35A, and the circuit boards 31A, 36A, and 36B may be defined as a second transceiver assembly.

The first lens tube 25A may extend between a first lens of the first receiving optical system 25 and the first window 191, improve a light incidence efficiency, and protect the lenses. The second lens tube 35A may extend between a first lens of the second receiving optical system 35 and the second window 192, improve a light incidence efficiency, and protect the lenses.

The first lens tube 25A may have a vertical opening height H1 different from a vertical opening height H2 of the second lens tube 35A. For example, the vertical opening height H1 of the first lens tube 25A may be greater than the vertical opening height H2 of the second lens tube 35A. The first lens tube 25A may have a horizontal opening length H3 different from a horizontal opening length H4 of the second lens tube 35A. For example, the horizontal opening length H3 of the first lens tube 25A may be less than the horizontal opening length H4 of the second lens tube 35A. When viewed from a side cross-section, a first optical axis passing through a center of the first lens tube 25A and a center of inner lenses thereof may be inclined based on a second optical axis passing through a center of the second lens tube 35A and a center of inner lenses thereof. The second optical axis is a horizontal optical axis, and the first optical axis may be inclined relative to the second optical axis.

The first light source array 21 is disposed outside the first lens tube 25A, and the second light source array 31 is disposed outside the second lens tube 35A.

The first receiving optical system 25 may have a vertical field of view different from that of the second receiving optical system 35. For example, the vertical field of view of the first receiving optical system 25 may be greater than that of the second receiving optical system 35. The first receiving optical system 25 may have a horizontal field of view different from that of the second receiving optical system 35. For example, the horizontal field of view of the first receiving optical system 25 may be less than that of the second receiving optical system 35. Also, the horizontal field of view and the vertical field of view of the first receiving optical system 25 may be different from each other. The horizontal field of view and the vertical field of view of the second receiving optical system 35 may be equal to each other. That is, one of the plurality of transceivers 120 and 130 may have different horizontal and vertical receiving fields of view, and the other may have the same horizontal and vertical field of view.

The first receiving optical system 25 of the first transceiver 120 may extend longitudinally from a third side surface to a fourth side surface of the main frame 170. The second receiving optical system 35 of the second transceiver 130 may extend longitudinally from the fourth side surface to the third side surface of the main frame 170. The third and fourth side surfaces may be both side surfaces of the main frame 170 in the first direction Y, and the first and second side surfaces may be both side surfaces of the main frame 170 in the second direction X. Each of the first to fourth side surfaces of the main frame 170 may include an accommodation part penetrating therethrough, and frames having a component for heat dissipation, i.e., a heat dissipation member, may be coupled to the accommodation part of each of the side surfaces.

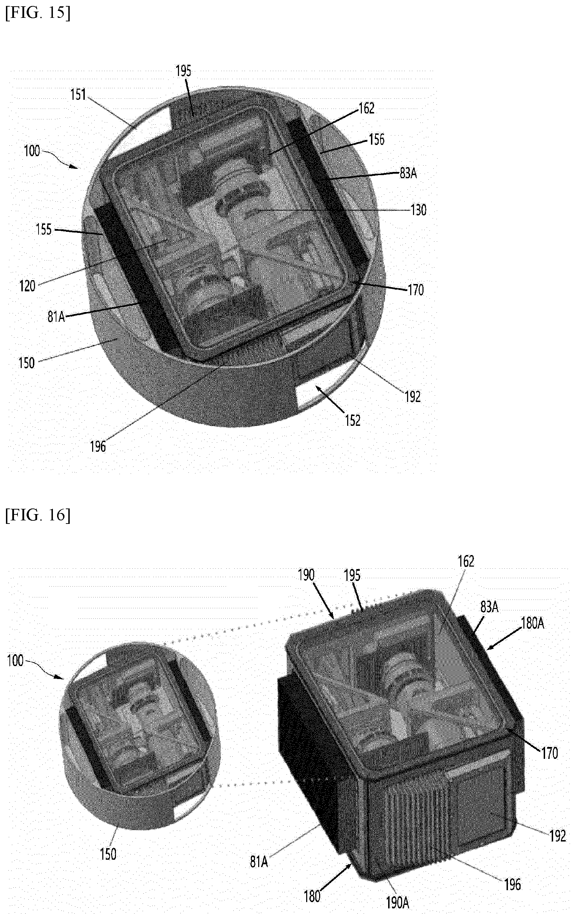

As illustrated in FIGS. 15 to 17, the main frame 170 may include an accommodation part 175 that accommodates the first transceiver 120 and the second transceiver 130. The main frame 170 may include a plurality of column frames 171, a lower frame 172, and an upper frame 173. The upper frame 173, the lower frame 172, and the column frames 171 may include a plurality of accommodation parts that are fasciae, for example, six accommodation parts or fasciae.

The upper frame 173, the lower frame 172, and the plurality of column frames 171 may be integrated with each other. For another example, at least one of the upper frame 173, the lower frame 172, and the plurality of column frames 171 may have a detachable structure. The upper frame 173 or the lower frame 172 may be provided separately, and the plurality of column frames 171 may be coupled to the upper frame 173 or the lower frame 172. At least one of the upper frame 173, the lower frame 172, and the plurality of column frames 171 may be detachably coupled.

The upper frame 173 and the lower frame 172 are spaced apart from each other by the column frames 171 to form a polygonal structure. The upper frame 173 may have a polygonal or circular shape having a hollow inside. The lower frame 172 may have a polygonal or circular shape having a hollow inside. The upper and lower frames 173 and 172 may have the same polygonal shape, e.g., a rectangular shape.

The column frames 171 connect and support corners of the upper and lower frames 173 and 172. The upper frame 173, the lower frame 172, and the column frames 171 may be integrated with each other. For another example, one or more upper frames 173 may be provided, and one or more lower frames 172 may be also provided. Also, at least one of the upper and lower frames 173 and 172 may be integrated or coupled with the column frames 171.

The upper frame 173 may have a recessed stepped structure at an inner circumference thereof to guide coupling of the polygonal upper covers 161 and 162. The lower frame 172 may have a recessed stepped structure at an inner circumference thereof and be coupled with the bottom frame 260 having a polygonal fitting structure. Also, each of the column frames 171 may have a recessed stepped structure in respective side directions of the main frame 170 to guide coupling of outer frames.

First to fourth frames 180, 180A, 190, and 190A may be coupled to respective side directions of the main frame 170. The first and second frames 180 and 180A may be coupled to both side surfaces of the main frame 170 in a second direction, and the third and fourth frames 190 and 190A may be coupled to both side surfaces of the main frame 170 in a first direction. Each of the first and second frames 180 and 180A may have a recessed stepped structure to be fitted with the stepped structure disposed along the inner side surfaces of the main frame 170. Also, each of the third and fourth frames 190 and 190A may have a recessed stepped structure to be fitted with the stepped structure disposed along the inner side surfaces of the main frame 170.

The third frame 190 may have a first window 191 facing the first transmitting and receiving optical systems 22 and 25, and a third heat dissipation member 195 may be disposed outside the third frame 190. The fourth frame 190A may have a second window 192 facing the second transmitting and receiving optical systems 32 and 35, and a fourth heat dissipation member 196 may be disposed outside the fourth frame 190A.

The first transceiver 120 may be coupled to the inside of the first frame 180, and the first heat dissipation member 81 and 81A may be disposed outside the first frame 180. The first heat dissipation member 81 and 81A may be disposed on an entire outer surface or both side surfaces of the first frame 180.

The second transceiver 130 may be coupled to the inside of the second frame 180A, and the second heat dissipation member 83 and 83A may be disposed outside the second frame 180A. The second heat dissipation member 83 and 83A may be disposed on an entire outer surface or both side surfaces of the second frame 180A.

The first frame 180 may include a first support part 183 therein, and the first support part 183 may support a portion of the first receiving optical system 25. The first support part 183 may has a first barrel hole TH1 (refer to FIG. 11). When the first receiving optical system 25 is inserted into the first barrel hole TH1, the first support part 183 may fix and support a position of the first receiving optical system 25.

The second frame 180A may include a second support part 184 therein, and the second support part 184 may support a portion of the second receiving optical system 35. The second support part 184 may has a second barrel hole TH2 (refer to FIG. 11). When the second receiving optical system 35 is inserted into the second barrel hole TH2, the second support part 184 may fix and support a position of the second receiving optical system 35. A locking unit may be further provided at the inside or the outside of the first and second barrel holes TH1 and TH2 to fix respective receiving optical systems. The locking unit may include a fastener.

Each of the first and second support parts 183 and 184 may be made of a thermally conductive metal material, e.g., at least one of an iron alloy, an aluminum alloy, or a magnesium alloy and provided as a mounting device of the circuit board to improve a heat dissipation efficiency of the inner space. Also, each of the first and second support parts 183 and 184 may further include a cooling fin at the outside thereof.

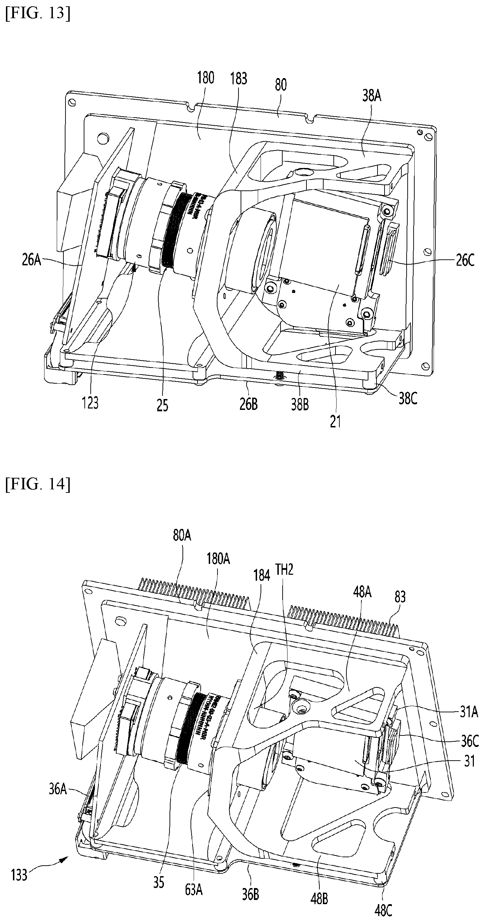

As illustrated in FIG. 13, the first frame 180 may include a first protection part 38A extending upward from the first support part 183 to the first light source array 21 and a second protection part 38B extending downward therefrom. Each of the first and second protection parts 38A and 38B may be bent from the first support part 183, and the second protection part 38B may be spaced apart from the first main substrate 26B by a spacer 38C. A distance between the first and second protection parts 38A and 38B may be greater than an outer diameter of the first lens tube 25A to protect the lens tube 25A.

As illustrated in FIG. 14, the second frame 180A may include a third protection part 48A extending upward from the second support part 184 to the second light source array 31 and a fourth protection part 48B extending downward therefrom. Each of the third and fourth protection parts 48A and 48B may be bent from the second support part 184, and the fourth protection part 48B may be spaced apart from the second main substrate 36B by a spacer 48C. A distance between the third and fourth protection parts 48A and 48B is greater than an outer diameter of the second lens tube 35A to protect the second lens tube 35A.

Also, the first and second protection parts 38A and 38B and the third and fourth protection parts 48A and 48B of the first and second support parts 183 and 184 may include holes therein to suppress increase in weight.

The first support part 183 may be integrated to the inside of the first frame 180 or separately attached thereto. The second support part 184 may be integrated to the inside of the second frame 180A or separately attached thereto.

An inner circumference of the first frame 180 may have a stepped structure and be coupled to the third side surface of the main frame 170. An inner circumference of the second frame 180A also may have a stepped structure and be coupled to the fourth side surface of the main frame 170.

The main frame 170 may be coupled to at least one upper cover 161 and 162. A circumference of the upper cover 161 or 162 may be inserted into or closely fitted to the upper frame 173 of the main frame 170. The upper cover 161 or 162 may have a plurality of fastening holes therein or along a circumference thereof and be fastened with the frames coupled to the main frame 170. The upper cover 161 or 162 may be transparent.

The upper cover 161 or 162 may be fastened to an inner fastening part of the housing 150. The upper cover 161 or 162 may have a circular or polygonal shape. That is, the upper cover 161 or 162 may have the same circular shape as an upper shape of the housing 150. For another example, the upper cover 161 or 162 may have the same polygonal shape as the upper shape of the main frame 170.

The main frame 170 may be coupled to the bottom frame 260. The bottom frame 260 may support a lower portion of each of the first and second transceivers 120 and 130. The bottom frame 260 may be coupled to the rotation frame 253. The bottom frame 260 may have an inner coupling hole and a coupling projection along an upper circumference and be fitted to the lower frame 172 of the main frame by the stepped structure of the upper circumference. Thus, the lower frame 172 may be closely attached to the circumference of the bottom frame 260.

The coupling holes of the bottom frame 260 may accommodate the upper structure of the rotation frame 253 and be coupled to a component and/or a support component of the main frame 170. That is, other frames and/or side covers may be coupled onto the coupling holes of the bottom frame 260 to prevent a displacement caused by rotation. Here, a plurality of frames 180, 180A, 190, and 190A may be coupled to side surfaces of the main frame 170, respectively. The plurality of frames may be the first to fourth frames 180, 180A, 190, and 190A disposed on respective side surfaces of the main frame 170.

The bottom frame 260 may have an outer shape that is a circular or polygonal shape and be coupled to the first to fourth frames 180, 180A, 190, and 190A using the coupling projections 262 protruding outward from respective side surfaces. The bottom frame 260 may include a plurality of insertion projections 261 on an inner circumference thereof and be coupled to holes (not shown) of the main boards 26B and 36B. The insertion projections 261 and the coupling projections 262 may prevent an individual movement of the bottom frame 260.

The bottom frame 260 may be coupled to a lower end of the housing 150. That is, the bottom frame 260 may have the same circular shape as a lower shape of the housing 150. Alternatively, the bottom frame 260 may have the same polygonal shape as the lower shape of the main frame 170.

A sealing member may be disposed between the main frame 170 and the bottom frame 260, between the main frame 170 and the upper cover 161, and between the main frame 170 and the first to fourth frames 180, 180A, 190, and 190A. The sealing member that is a cleaning component may be made of a rubber material and block moisture and foreign substances introduced through respective side surfaces of the main frame 170.

The first heat dissipation members 81 and 81A may be disposed on one side of the first circuit board 26A and one side of the first light source array 21, respectively. The first heat dissipation members 81 and 81A may be disposed between the housing 150 and the main frame 170. The second heat dissipation members 83 and 83A may be disposed on one side of the second circuit board 36A and one side of the second light source array 31, respectively. The second heat dissipation members 83 and 83A may be disposed between the housing 150 and the main frame 170. Each of the first heat dissipation members 81 and 81A and the second heat dissipation members 83 and 83A may include vertically arranged heat dissipation fins. The second heat dissipation members 83 and 83A may include vertically arranged heat dissipation fins.

The third heat dissipation member 195 may be disposed at the outside of the first sensor array 26, i.e., at the outside of the first circuit board 26A at which the first sensor array 26 is disposed, to dissipate heat generated by the first sensor array 26. The fourth heat dissipation member 196 is disposed at the outside of the second sensor array 36, i.e., at the outside of the second circuit board 36A at which the second sensor array 36 is disposed, to dissipate heat generated by the second sensor array 36. The third and fourth heat dissipation members 195 and 196 may have vertically arranged heat dissipation fins. Respective areas of the third and fourth heat dissipation members 195 and 196 may be less than those of the first and second heat dissipation members 81A and 83A. The area of each heat dissipation member is a size of an area on which the heat dissipation fins are arranged.

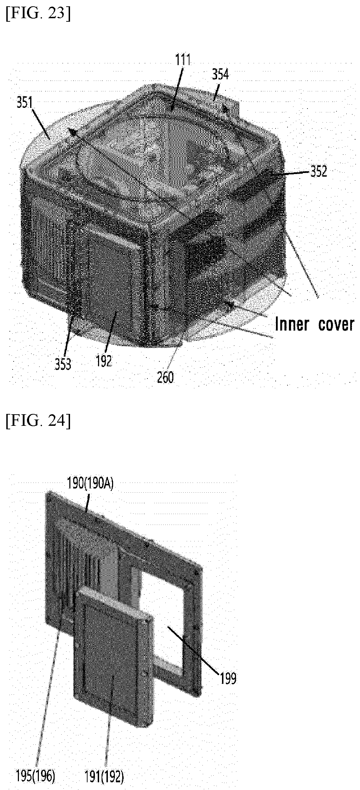

As illustrated in FIGS. 15 and 16, the first to fourth heat dissipation members 81A, 83A, 195, and 196 may be disposed in the housing 150. Each of the heat dissipation fins of the third and fourth heat dissipation members 195 and 196 may have a width (horizontal width) that gradually decreases in a rotation direction while having the same vertical length. The first window hole 151 may face the first light source array 21 and the first receiving optical system 22 of the first transceiver 120, and the second window hole 152 may face the second light source array 31 and the second receiving optical system 32 of the second transceiver 130. The first and second windows 191 and 192 may be coupled to respective coupling holes of the third and fourth frames 190 and 190A, respectively (refer to FIG. 24).

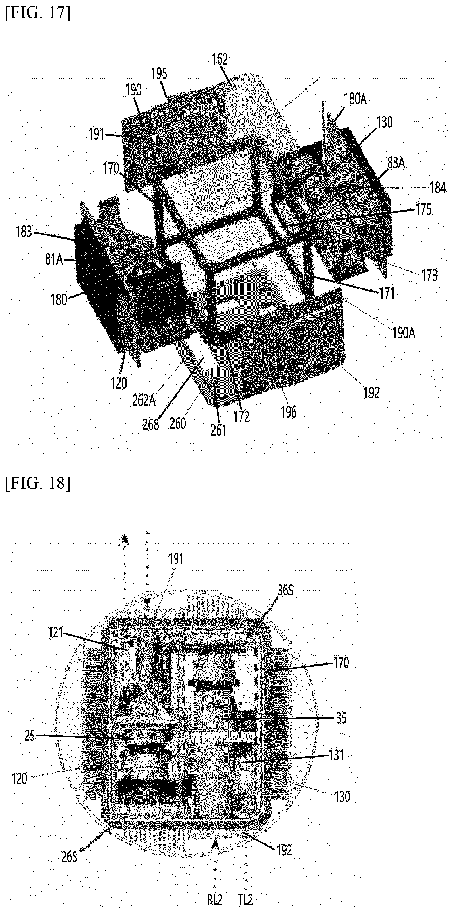

FIG. 17 is a view illustrating another example of the bottom frame 260. The bottom frame 260 may have a polygonal shape, and heat dissipation holes 268 may be defined in areas corresponding to lower areas of the heat dissipation fins of respective heat dissipation members 81, 81A, 195, and 196.

As illustrated in FIGS. 15, 16, and 18, the housing 150 may further include inner walls 155 and 156 disposed at an outer side to face outer surfaces of the first and second heat dissipation members 81A and 83A. Accordingly, the first and second heat dissipation members 81A and 83A may contact the inner walls 155 and 156 of the housing 150 to improve a heat dissipation efficiency through the housing 150. A first window 191 may be disposed at one side of the third heat dissipation member 195, and a second window 192 may be disposed at the other side of the fourth heat dissipation member 196. The first window 191 may be disposed further outward than the first side surface of the main frame 170, and the second window 192 may be disposed further outward than the second side surface of the main frame 170. The first and second heat dissipation members 81A and 83A may face outer sides 26S and 36S of the first and second circuit boards 26A and 36A at which the first and second sensor arrays 26 and 36 are disposed.

The first window 191 may face outer sides of the first receiving optical system 25 and the first light source array 21. The first window 191 may face outer sides of the second light source array 31 and the lens tube 25A of the first receiving optical system 25. The second window 192 may face outer sides of the second light source array 31 and the second receiving optical system 35. The second window 192 may face outer sides of the second light source array 31 and the lens tube 35A of the second receiving optical system 35.

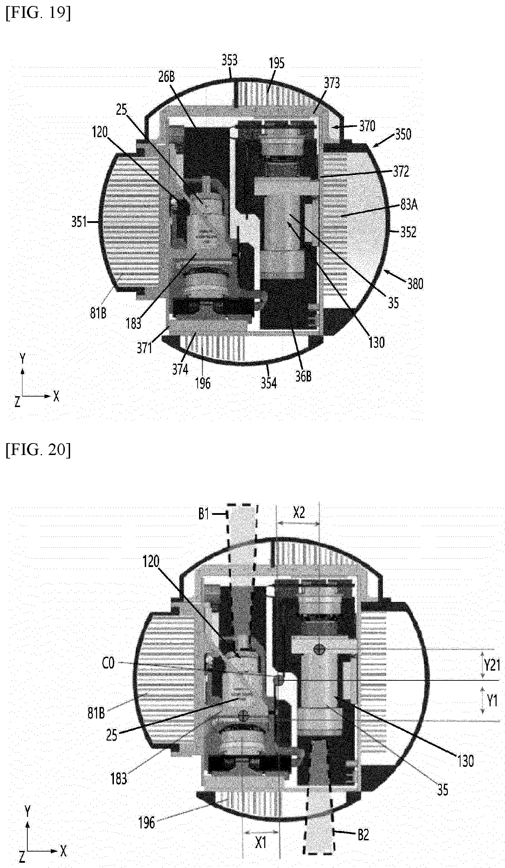

FIG. 19 is a view illustrating another example of the housing 150 and/or the heat dissipation member. As illustrated in FIG. 19, the LiDAR device may further include an inner cover 350 in the housing 150. The inner cover 350 may be in close contact with outer surfaces of the first to fourth heat dissipation members 81B, 83A, 195, and 196.

The inner cover 350 includes heat dissipation covers 351, 352, 353, and 354 outside respective heat dissipation members 81B, 83A, 195, and 196 of the main frame 370. The heat dissipation covers 351, 352, 353, and 354 may be disposed in the housing 150. The heat dissipation covers 351, 352, 353, and 354 may be disposed between the housing 150 and the heat dissipation members 81B, 83A, 195, and 196. The heat dissipation covers 351, 352, 353, and 354 may have a curved shape and disposed outside the respective heat dissipation members 81B, 83A, 195, and 196. For example, the first heat dissipation cover 351 may be disposed outside the first heat dissipation member 81B, the second heat dissipation cover 352 may be disposed outside the second heat dissipation member 83A, the third heat dissipation cover 353 may be disposed outside the third heat dissipation member 195, and the fourth heat dissipation cover 354 may be disposed outside the fourth heat dissipation member 196.

The first heat dissipation cover 351 may have a hemispherical shape and be coupled to one side of the main frame 370. The second heat dissipation cover 352 may have a hemispherical shape and be coupled to the other side of the main frame 370. Here, the first, third, and fourth heat dissipation members 81B, 195, and 196 may have different horizontal lengths so that outer shapes of the heat dissipation fins face the hemispherical heat dissipation covers 351, 353, and 354.

The adjacent heat dissipation covers 351, 352, 353, and 354 may be coupled to each other or coupled through the main frame 370. Also, the main frame 370 may be separated into a plurality of components and coupled to each other through fastening members. Also, the main frame 370 may include frames 371, 372, 373, and 374 disposed on respective side surfaces thereof. In this case, as the main frame 370 or the respective side frames are disposed, the number of frames may be reduced. Both ends of the third frame 190 may be bent to face outer one end of each of the third and fourth frames.

The respective heat dissipation covers 351, 352, 353, and 354 may cover an outer side, side surfaces, and a top surface of each of the heat dissipation members 81B, 83A, 195, and 196.

As illustrated in FIG. 20, the first transceiver 120 may scan and sense in a first beam shape B1, and the second transceiver 130 may scan and sense in a second beam shape B2. At least one or both of the first and second transceivers may not have a lens tube.

A center of the first receiving optical system 25 and a center of the second receiving optical system 35 may be spaced the same distance Y1 and Y2 from a center C0 of the LiDAR device in the first direction Y. The center of the first receiving optical system 25 and the center of the second receiving optical system 35 may be spaced the same distance X1 and X2 from a center of the LiDAR device in the second direction X. When disposed on respective central positions of the first and second receiving optical systems 25 and 35, the centers of gravity of the first and second transceivers 120 and 130 may be equally spaced in the first and second directions Y and X and disposed at opposite sides based on a rotation center.

As illustrated in FIG. 21, the first transceiver 120 may have a first vertical field of view R1, and the second transceiver 130 may have a second vertical field of view R2 at the outside of the housing 150. Based on a horizontal axis Z1, the second vertical field of view R2 may be less than the first vertical field of view R1. Here, the vertical field of view may be an angle between two straight lines extending from upper and lower ends of an entrance side of each lens tube.

The housing 150 may have a diameter Y2 greater than that of each of the rotation frame 253 and/or the fixed frame 251.

As illustrated in FIGS. 22 and 23, the third frame 190 may have a window hole facing the first window 191 and a third heat dissipation cover 353 for covering the third heat dissipation member 195. The third heat dissipation cover 353 may protrude further outward than the first window 191 to protect the first window 191.

The fourth frame 190A may have a window hole facing the second window 192 and a fourth heat dissipation cover 354 for covering the outside of the fourth heat dissipation member 196. The fourth heat dissipation cover 354 may protrude further outward than the second window 192 to protect the second window 192.

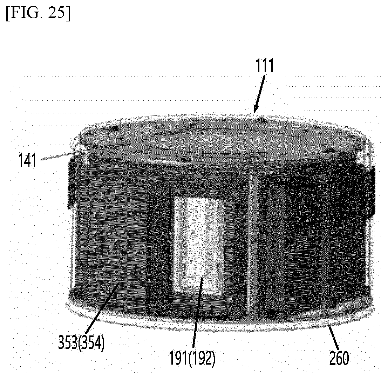

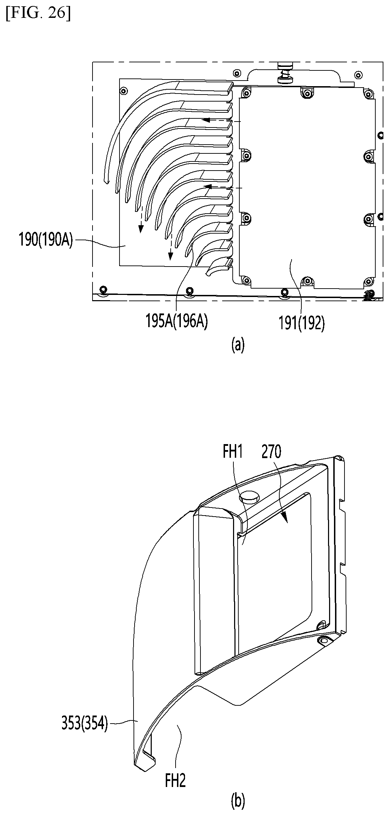

As illustrated in FIGS. 24 to 26, the third and fourth heat dissipation covers 353 and 354 may each have a window hole 270, be fastened to the third and fourth frames 190 and 190A, respectively, and each have a hole 199 to which the window 191 and 192 is coupled.

The third and fourth heat dissipation covers 353 and 354 may be disposed outside the third and fourth heat dissipation members 195 and 196. Each of air guides 195A and 196A of the third and fourth heat dissipation members 195 and 196 may have a curved shape instead of being vertically arranged. The air guides having relatively longer lengths among the curved air guides 195A and 196A may have linear and curved shapes. The air guides disposed at upper sides among the curved air guides 195A and 196A may have linear and curved shapes. The linear shape of the air guides 195A and 196A may be disposed on an area adjacent to the windows.

One end of each of the a plurality of air guides 195A and 196A may guide a flow of air introduced in a rotation direction or through a lower second flow path groove FH2 because the areas adjacent to the windows 191 and 192 may be arranged at different heights. For example, the other ends of the a plurality of air guides 195A and 196A may guide the introduced air toward the bottom frame 260. On the contrary, when external air is introduced through the lower second flow path groove FH2, the air guides 195A and 196A may guide the air introduced from a lower side, dissipate heat generated by inner heat-generating components (e.g., 26A and 36A), and guide the air toward the windows 191 and 192 disposed on one side surface of the air guides 195A and 196A.

To this end, the bottom frame 260 may have heat dissipation holes 268 corresponding to lower portions of the third and fourth heat dissipation members 195 and 196. The heat dissipation holes 268 may be arranged on an area corresponding to the respective heat dissipation fins and an area corresponding to the respective air guides 195A and 196A, respectively. That is, one ends of the air guides 195A and 196A may be arranged parallel to a rotation direction of the rotation head. The other ends of the air guides 195A and196A may face the heat dissipation holes 268 (refer to FIG. 17) of the bottom frame 260.

The third and fourth heat dissipation covers 353 and 354 may include a first flow path groove FH1 therein and a second airflow groove FH2 at a lower side. The first airflow groove FH1 may be connected to the window hole 270 and correspond to one end of each of the a plurality of air guides 195A and 196A. The second flow path groove FH2 may correspond to the heat dissipation hole 268 of the bottom frame 260 and the other end of each of the a plurality of air guides 195A and 196A.

As illustrated in FIGS. 27 and 28, the housing 150 and the upper cover 161 may be fastened through a fastening member 90. The fastening member 90 may be fastened to the fastening groove 93 of the housing 150 through the upper cover 161. An elastic spring 95 of the fastening member 90 may provide elasticity between the housing 150 and the fastening body 96, so that the housing 150 and the upper cover 161 closely contact each other to relieve a vertical impact. Also, the lower circumference of the housing 150 and the bottom frame 260 may be fastened through a fastening member (not shown). The housing 150 may be fastened to the upper cover 161 and 162 and/or the frame, and also fastened to the bottom frame 260.

Features, structures, and effects described in the above embodiments are incorporated into at least one embodiment of the present disclosure, but are not limited to only one embodiment. Moreover, features, structures, and effects exemplified in one embodiment may easily be combined and modified for another embodiment by those skilled in the art. Therefore, these combinations and modifications should be construed as falling within the scope of the present disclosure. Moreover, features, structures, and effects exemplified in one embodiment may easily be combined and modified for another embodiment by those skilled in the art. Therefore, these combinations and modifications should be construed as falling within the scope of the present invention. Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A LiDAR device comprising:
a main frame having an accommodation part therein;
a plurality of transceivers which are disposed in the accommodation part and each of which emits a laser beam toward an object in different directions and senses the laser beam reflected by the object; and
a bottom frame disposed below the main frame.

2. The LiDAR device of claim 1, wherein the plurality of transceivers comprise:
a first transceiver configured to emit and sense a laser beam in a first direction; and
a second transceiver configured to emit and sense a laser beam in a direction opposite to the first direction.

3. The LiDAR device of claim 1, further comprising an upper cover or an upper frame disposed above the first and second transceivers and coupled to an upper inner circumference of the main frame,
wherein the bottom frame is coupled to a lower inner circumference of the main frame.

4. The LiDAR device of claim 2, wherein each of side surfaces of the main frame comprises an accommodation part passing therethrough, and
wherein the LiDAR device further comprises frames having heat dissipation members respectively coupled to the accommodation parts on each of the side surfaces of the main frame.

5. The LiDAR device of claim 3, further comprising a first window disposed at a beam incidence side of the first transceiver and a second window disposed at a beam incidence side of the second transceiver,
wherein each of the first and second windows is disposed outward relative to the main frame.

6. The LiDAR device of claim 5, wherein the first transceiver comprises a first receiving optical system and a first sensor array,
wherein the second transceiver comprises a second receiving optical system and a second sensor array, and
wherein the LiDAR device further comprises a first lens tube disposed between the first receiving optical system and the first window, and a second lens tube disposed between the second receiving optical system and the second window.

7. The LiDAR device of claim 4, further comprising heat dissipation covers that cover the heat dissipation members disposed on the side surfaces of the main frame, respectively,
wherein each of the heat dissipation covers has a hole that exposes the window.

8. The LiDAR device of claim 4, wherein the bottom frame has a heat dissipation hole corresponding to a lower portion of each of the heat dissipation members.

9. The LiDAR device of claim 7, further comprising a housing that covers upper and outer portions of the main frame,
wherein the housing comprises a window hole corresponding to the hole of each of the heat dissipation covers.

10. The LiDAR device of any one of claims 1 to 8, further comprising:
a fixed frame fixed to a moving body and having a stator; and
a rotation frame having a rotor that faces the stator and configured to rotate axially on the fixed frame,
wherein the rotation frame allows the main frame, the bottom frame, and the plurality of transceivers to rotate.

11. The LiDAR device of any one of claims 1 to 8, wherein the plurality of transceivers has different incident receiving fields of view.
